# EUROPEAN PATENT APPLICATION

(11) **EP 3 723 116 A1**
(43) Date of publication of application: **14.10.2020**
(21) Application number: 18905755.7
(22) Date of filing: 09.02.2018
(51) Int. Cl.: H01L 21/52

(54) **SEMICONDUCTOR DEVICE HAVING HIGHLY STABLE BONDING LAYER AND MANUFACTURING METHOD FOR DEVICE**

(71) Applicant: HUAWEI TECHNOLOGIES CO., LTD., Shenzhen, Guangdong 518129, (CN)
(72) Inventor: YANG, Renyi, Shenzhen, Guangdong 518129 (CN); XU, Peng, Shenzhen, Guangdong 518129 (CN); TENG, Hui, Shenzhen, Guangdong 518129 (CN); LI, Xiaoyong, Shenzhen, Guangdong 518129 (CN); CHEN, Tewei, Shenzhen, Guangdong 518129 (CN); HAN, Mei, Shenzhen, Guangdong 518129 (CN); ZHANG, Ren, Shenzhen, Guangdong 518129 (CN); WEI, Lei, Shenzhen, Guangdong 518129 (CN)
(74) Representative: Grünecker Patent- und Rechtsanwälte PartG mbB
(86) International application number: PCT/CN2018/075947
(87) International publication number: WO 2019/153230

(57) **Abstract**

A semiconductor apparatus (400) and a production method thereof are disclosed. In the semiconductor apparatus (400), a bonding layer (43) used to bond a semiconductor chip (41) and a substrate (42) includes sintered metal made through a process of sintering metal powder with high electrical and thermal conductivity. In addition, at least some voids (431) inside the sintered metal are filled with a specific material. After the voids (431) are filled with the specific material, less moisture is gathered in the voids, and this reduces a possibility of delamination between the chip (41) and the substrate (42) when the semiconductor apparatus (400) is surface-mounted onto a printed circuit board through reflow soldering. In addition, the filled voids (431) do not interfere with a detection result of delamination, and accuracy of the detection result of delamination of the semiconductor apparatus (400) is improved.

## Description

### TECHNICAL FIELD

This application relates to the field of semiconductor chip packaging technologies, and in particular, to a semiconductor apparatus and a production method thereof.

### BACKGROUND

Because an epoxy molding compound (Epoxy Molding Compound, EMC) material has relatively low costs and is suitable for large-scale automated production, EMC packaging is usually used for a semiconductor chip. A structure obtained through the EMC packaging is referred to as an EMC packaging structure or molding structure.

Currently, a semiconductor chip molding structure used in the industry has the following defects:

First, after the semiconductor chip molding structure is exposed to a humid environment for a long time, when a component of the semiconductor chip molding structure is surface-mounted onto a printed circuit board through reflow soldering, a bonding material between the semiconductor chip and a line substrate may fail, causing delamination between the semiconductor chip and the line substrate.

Second, accuracy of detecting whether there is delamination in the semiconductor chip molding structure is relatively low.

### SUMMARY

In view of this, embodiments of this application provide a semiconductor apparatus and a production method thereof, to overcome the foregoing defects.

To resolve the foregoing technical problems, the following technical solutions are used in this application:

A first aspect of this application provides a semiconductor apparatus, including:
a semiconductor chip, a substrate, and a bonding layer located between the semiconductor chip and the substrate, and the bonding layer is used to bond the semiconductor chip and the substrate, where the bonding layer includes sintered metal; a plurality of voids are inside the sintered metal, and at least some of the voids are filled with a specific material; and the specific material has fluidity at a temperature higher than a preset temperature, and can be cured after being heated and melted.

According to the semiconductor apparatus provided in this application, because the at least some of the voids inside the sintered metal are filled with the specific material, a probability that moisture in an external environment gathers inside the semiconductor apparatus is reduced, and a possibility of delamination between the chip and the substrate when the semiconductor apparatus is surface-mounted onto a printed circuit board through reflow (reflow) soldering is reduced. In addition, a scanning acoustic tomography image of the voids filled with the specific material is substantially different from an image of internal delamination of the semiconductor. Therefore, accuracy of detecting internal delamination of the semiconductor apparatus is relatively high.

With reference to the first aspect of this application, in a first possible implementation, the semiconductor apparatus further includes a molding package wrapping around the semiconductor chip and the bonding layer, and the specific material is the same as a molding material corresponding to the molding package.

In this implementation, the molding package can protect the semiconductor chip and the bonding layer inside the molding package, thereby improving reliability of the semiconductor apparatus. In addition, this implementation can simplify a manufacturing process of the semiconductor apparatus, and reduce manufacturing costs.

With reference to the first aspect of this application and the first possible implementation of the first aspect, in a second possible implementation, at least 85% of the voids inside the sintered metal are filled with the specific material.

With reference to the second possible implementation of the first aspect of this application, in a third possible implementation, at least 90% of the voids inside the sintered metal are filled with the specific material.

When a higher proportion of voids are filled with the specific material, a possibility of delamination due to moisture gathered in the voids is lower, and accuracy of detecting an internal delamination status by using a scanning acoustic tomography is higher.

With reference to the first aspect of this application and the possible implementations of the first aspect, in a fourth possible implementation, a first metal layer is disposed on a semiconductor chip surface that is bonded to the bonding layer, and a first metal alloy layer is formed between the first metal layer and the bonding layer due to a metallic bonding force.

This implementation can improve performance of connection between the semiconductor chip and the bonding layer, and reduce a possibility of delamination between the semiconductor chip and the bonding layer.

With reference to the first aspect of this application and the possible implementations of the first aspect, in a fifth possible implementation, a second metal layer is disposed on a substrate surface that is bonded to the bonding layer, and a second metal alloy layer is formed between the second metal layer and the bonding layer due to a metallic bonding force.

This implementation can improve performance of connection between the substrate and the bonding layer, and reduce a possibility of delamination between the substrate and the bonding layer.

With reference to the first aspect of this application, in a sixth possible implementation, after the bonding layer is formed through a sintering and curing process, the specific material is led from the outside of the bonding layer into the voids, to fill the voids.

With reference to the first aspect of this application and the possible implementations of the first aspect, in a seventh possible implementation, the sintered metal is sintered silver. This implementation can improve thermal conductivity and electrical conductivity of the bonding layer.

With reference to the first aspect of this application and the possible implementations of the first aspect, in an eighth possible implementation, the metal powder includes at least one of nanometer metal particles and micrometer metal particles.

With reference to the first aspect of this application and the possible implementations of the first aspect, in a ninth possible implementation, the sintered metal is made of the metal powder through a sintering process.

A second aspect of this application provides a semiconductor apparatus production method. The production method includes:
forming a bonding layer between a semiconductor chip and a substrate through a sintering and curing process, where the bonding layer is used to bond the semiconductor chip and the substrate, the bonding layer is made of sintered metal, and a plurality of voids are inside the sintered metal; and filling at least some of the voids with a specific material, where the specific material has fluidity at a temperature higher than a preset temperature, and can be cured after being heated and melted.

Because the at least some of the voids inside the sintered metal are filled with the specific material, a probability that moisture in an external environment gathers inside the semiconductor apparatus is reduced, and a possibility of delamination between the chip and the substrate when the semiconductor apparatus is surface-mounted onto a printed circuit board through reflow (reflow) soldering is reduced. In addition, a scanning acoustic tomography image of the voids filled with the specific material is substantially different from an image of internal delamination of the semiconductor. Therefore, accuracy of detecting internal delamination of the semiconductor apparatus is relatively high.

With reference to the second aspect of this application, in a first possible implementation, the production method further includes: forming a molding package wrapping the semiconductor chip and the bonding layer, where the specific material is the same as a molding material corresponding to the molding package.

In this possible implementation, the molding package can protect the semiconductor chip and the bonding layer inside the molding package, thereby improving reliability of the semiconductor apparatus.

With reference to the first possible implementation of the second aspect of this application, in a second possible implementation, the filling at least some of the voids with a specific material specifically includes: flowing, by the flowing molding material, into the at least some of the voids when the molding package is formed, so that the at least some of the voids are filled with the molding material.

This possible implementation can simplify a packaging process of the semiconductor apparatus, and reduce packaging costs.

With reference to the second aspect of this application and the possible implementations of the second aspect, in a third possible implementation, after the forming a molding package wrapping the semiconductor chip and the bonding layer, the production method further includes: curing the molding package.

With reference to the second aspect of this application, in a fourth possible implementation, the filling at least some of the voids with a specific material specifically includes: heating the specific material to a temperature higher than the preset temperature, so that the specific material can flow; and injecting the flowing specific material into the at least some of the voids in the bonding layer.

This possible implementation can improve an effect of filling the voids.

With reference to the fourth possible implementation of the second aspect of this application, in a fifth possible implementation, after the injecting the fluid into the at least some of the voids in the bonding layer by using a capillary force, the production method further includes:
placing the structure filled with the specific material in a specific temperature condition, and post-curing the fluid injected into the voids. The possible implementation can improve reliability of the semiconductor apparatus.

With reference to the second aspect of this application and the possible implementations of the second aspect, in a sixth possible implementation, at least 85% of the voids inside the sintered metal are filled with the specific material.

This possible implementation can reduce a possibility of delamination between the chip and the substrate when the semiconductor apparatus is surface-mounted onto a printed circuit board through reflow (reflow) soldering. In addition, accuracy of detecting internal delamination of the semiconductor apparatus is improved.

With reference to the second aspect of this application and the possible implementations of the second aspect, in a seventh possible implementation, a first metal layer is disposed on a semiconductor chip surface that is bonded to the bonding layer, and a first metal alloy layer is formed between the first metal layer and the bonding layer due to a metallic bonding force.

This possible implementation can improve performance of connection between the semiconductor chip and the bonding layer, and reduce a possibility of delamination between the semiconductor chip and the bonding layer.

With reference to the second aspect of this application and the possible implementations of the second aspect, in an eighth possible implementation, a second metal layer is disposed on a substrate surface that is bonded to the bonding layer, and a second metal alloy layer is formed between the second metal layer and the bonding layer due to a metallic bonding force.

This possible implementation can improve performance of connection between the substrate and the bonding layer, and reduce a possibility of delamination between the substrate and the bonding layer.

With reference to the second aspect of this application and the possible implementations of the second aspect, in a ninth possible implementation, the sintered metal is sintered silver.

Compared with the prior art, this application has the following beneficial effects:

It can be learned from the foregoing technical solutions that, in the semiconductor apparatus provided in the embodiments of this application, the bonding layer used to bond the semiconductor chip and the line substrate is made of the sintered metal, and the sintered metal is made through a process of sintering metal powder with high electrical and thermal conductivity. In addition, in this embodiment of this application, at least some of the voids inside the sintered metal are filled with the specific material. After the voids are filled with the specific material, less moisture is gathered inside the voids, and a relatively large amount of moisture in an external environment is prevented from gathering inside a semiconductor chip molding structure. Further, delamination between the chip and the substrate caused when external moisture gathers inside is avoided. Therefore, when the semiconductor apparatus is exposed to a humid environment, a probability that moisture in the external environment gathers inside the semiconductor molding structure is greatly reduced. Therefore, a possibility of delamination between the chip and the substrate when the semiconductor apparatus is surface-mounted onto the printed circuit board through reflow (reflow) soldering is reduced.

In addition, scanning acoustic tomography detection (Scanning Acoustic Tomography, or SAT) is used to detect whether there is delamination in the semiconductor apparatus. It is difficult to distinguish between a scanning acoustic tomography image of the voids inside the sintered metal and a scanning acoustic tomography image of the delamination. However, a scanning acoustic tomography image of the filled voids in the sintered metal is substantially different from a scanning acoustic tomography image of the delamination between the chip and the line substrate in the semiconductor apparatus. Based on this, the image of the filled voids can be easily excluded by using the scanning acoustic tomography image, thereby reducing interference to detection of delamination. Therefore, accuracy of detecting internal delamination of the semiconductor apparatus provided in this embodiment of this application is relatively high.

### BRIEF DESCRIPTION OF DRAWINGS

FIG. 1 is a schematic diagram of a semiconductor chip molding structure commonly used in the art;
FIG. 2 is a schematic structural diagram of bonding a semiconductor chip and a line substrate by using sintered silver in the art;
FIG. 3 is a schematic diagram of a principle of internal delamination that occurs in a semiconductor chip molding structure;
FIG. 4' is a perspective view of a semiconductor apparatus according to an embodiment of this application;

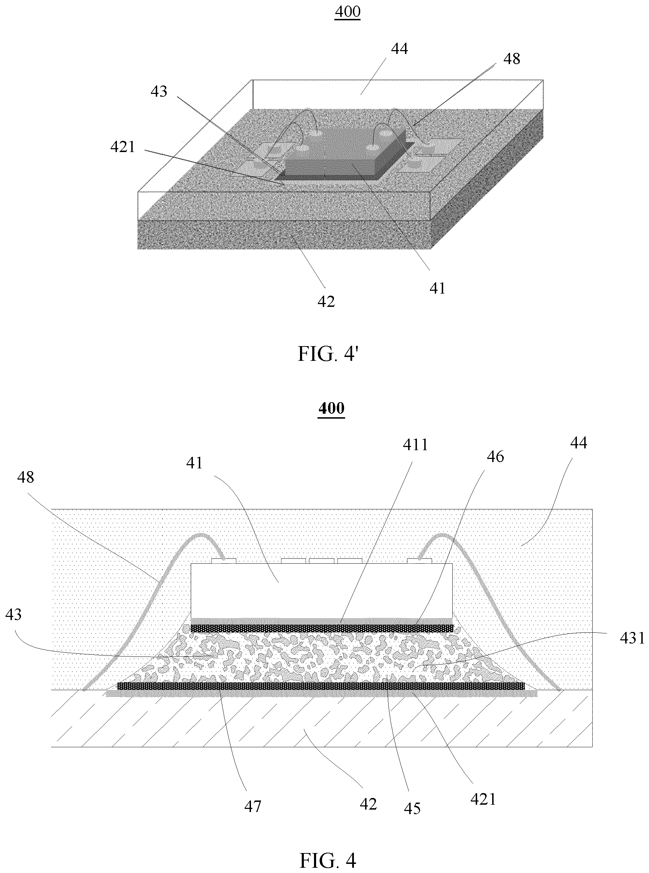

FIG. 4 is a schematic cross-sectional diagram of a semiconductor apparatus according to an embodiment of this application;

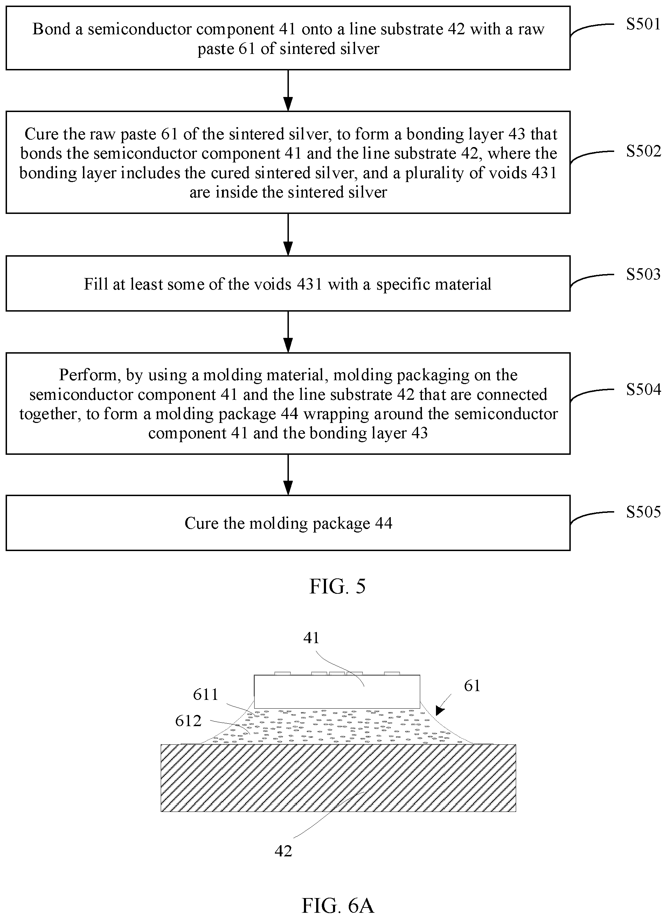

FIG. 5 is a schematic flowchart of a semiconductor apparatus production method according to an embodiment of this application;
FIG. 6A to FIG. 6C are schematic cross-sectional structural diagrams corresponding to a series of manufacturing processes of a semiconductor apparatus production method according to an embodiment of this application; and

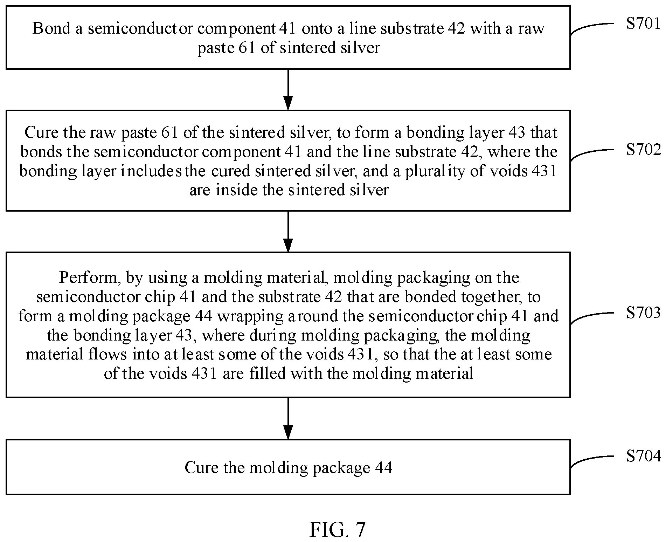

FIG. 7 is a schematic flowchart of another semiconductor apparatus production method according to an embodiment of this application.

### Reference numerals:

- 11, 21, 41:: Semiconductor chip;
- 12, 22, 42:: Substrate;
- 13:: Conductive adhesive;
- 23:: Silver paste;
- 231, 611:: Nanometer or micrometer silver powder particles;
- 232, 612:: Auxiliary solvent;
- 24:: Sintered silver block;
- 400:: Semiconductor chip molding structure;
- 43:: Bonding layer (for example, a sintered silver structure);
- 44:: Molding package;
- 45:: Specific material;
- 431:: Voids;
- 411:: First metal layer;
- 421:: Second metal layer;
- 46:: First metal alloy layer;
- 47:: Second metal alloy layer;
- 48:: Metallic bonding wire;
- 61:: Raw paste of sintered silver.

### DESCRIPTION OF EMBODIMENTS

It should be understood that in this application, "at least one (item)" refers to one or more, and "a plurality of' refers to two or more. The term "and/or" is used to describe an association relationship between associated objects, and indicates that three relationships may exist. For example, "A and/or B" may indicate the following three cases: Only A exists, only B exists, and both A and B exist, where A and B may be singular or plural. The character "/" generally indicates an "or" relationship between the associated objects. "At least one of the following" or a similar expression thereof indicates any combination of the following, including any combination of one or more of the following. For example, at least one of a, b, or c may indicate a, b, c, "a and b", "a and c", "b and c", or "a, b, and c", where a, b, and c may be singular or plural.

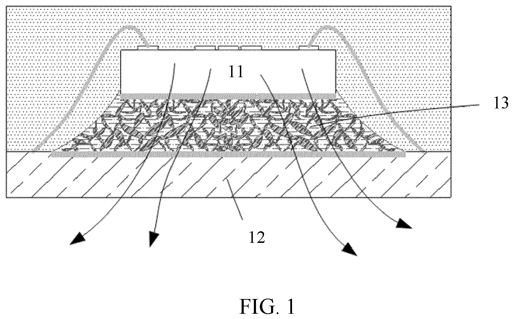

As shown in FIG. 1, semiconductor chip molding structure usually includes a semiconductor chip 11 and a substrate 12. The semiconductor chip 11 is usually bonded to the substrate 12 with a conductive adhesive 13. As an example, the substrate 12 may be a printed circuit board or a ceramic circuit board. In an optional case, when the substrate is a printed circuit board or a ceramic circuit board, the circuit board may be used to lay a printed circuit, to transmit an electrical signal. In addition, heat is generated when the semiconductor chip 11 works, and a main heat dissipation way of the semiconductor chip is heat dissipation through conduction. The circuit board may further have a heat dissipation function, to transfer the heat generated by the semiconductor chip 11 to the outside of the molding structure. Specifically, as shown in FIG. 1, the heat generated by the semiconductor chip 11 may be conducted and dissipated through the conductive adhesive 13 and the substrate 12 below the semiconductor chip 11.

Featuring simple operation, stable performance, and good electrical conductivity in bonding, a silver epoxy (Silver epoxy) adhesive is usually used as a typical material for molding packaging of the semiconductor chip. However, a thermal conductivity of the silver epoxy adhesive is relatively low, and is generally less than 10 w/m·k (w/m·k). In application of a high-power chip, the silver epoxy adhesive cannot quickly and effectively dissipate heat generated when the semiconductor chip 11 works. As a result, a temperature of a PN junction (PN junction) (referred to as a junction temperature below) of the semiconductor chip increases, shortening a lifespan of the chip. In addition, a surface of the semiconductor chip 11 and a surface of the substrate 12 that are in contact with the conductive adhesive 13 are usually metal layer surfaces, and the conductive adhesive 13 is usually an organic resin system. The conductive adhesive 13 and the material in contact with the conductive adhesive 13 are not a same system, and therefore bonding is relatively poor. When stress at an interface is excessively strong, for example, stress generated when a material expands with heat and contracts with cold when a temperature of an application environment of the chip changes greatly is excessively strong, a bond between the chip and the substrate may easily peel off, causing delamination.

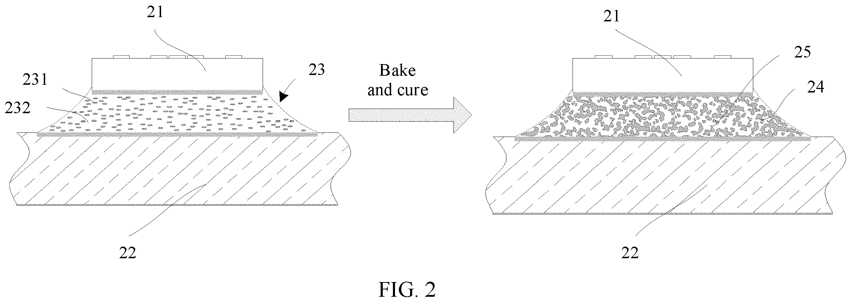

To overcome the defects of the conductive adhesive, in recent years, another new bonding material has appeared and been applied to EMC packaging. The new bonding material is sintered metal, for example, sintered silver. The sintered metal is formed by sintering metal particles at a high temperature (for the sintered silver, a sintering temperature is 170°C to 300°C). As shown in FIG. 2, a specific bonding process is illustrated by using the sintered silver as an example: A silver paste 23 is disposed between a semiconductor chip 21 and a substrate 22. The silver paste 23 is made up of nanometer or micrometer silver powder particles 231 and an auxiliary solvent 232. The auxiliary solvent 232 may be, for example, one of butyl anhydride acetate ester, diethylene glycol butyl ether acetate ester, diethylene glycol ether acetate ester, or isophorone. It should be understood that, the auxiliary solvent 232 is not limited to the several solvents listed above. The auxiliary solvent 232 is volatile to some extent, and can be volatile at a particular temperature. In addition, the auxiliary solvent 232 has a lubrication effect in the silver paste 23, so that the silver powder particles 231 can flow.

After the silver paste 23 is baked at a high temperature, the auxiliary solvent 232 is fully volatilized, and the nanometer or micrometer metal powder particles crystallize and gather into a sintered silver block 24, and a plurality of voids 25 remain inside the sintered silver block 24.

The sintered metal has functions of bonding, electrical conduction and thermal conduction. In addition, compared with the conductive adhesive, thermal conductivity of the sintered metal is relatively high. For example, the thermal conductivity of the sintered silver reaches 100 w/m·k or higher. Then, a weakness of low thermal conductivity of the silver epoxy adhesive is completely overcome. In addition, in a sintering process, the sintered metal forms a metallic bond alloy (metallic bond alloy) with metal of a contact interface of the sintered metal. Then, the sintered metal forms a good bond with the surface of the chip and the surface of the substrate that are in contact with the sintered metal. Therefore, this also overcomes a weakness of poor bonding and easy delamination between the semiconductor chip and substrate caused because interface materials are not a same system.

However, a semiconductor chip molding structure that uses the sintered metal to bond the semiconductor chip and the substrate has the defects described in the background, which are specifically as follows:

First, after the semiconductor chip molding structure is exposed to a humid environment for a long time, when a component of the semiconductor chip molding structure is surface-mounted onto a printed circuit board through reflow soldering, delamination between the chip and the substrate may be caused.

Second, accuracy of detecting whether there is delamination in the semiconductor chip molding structure is relatively low.

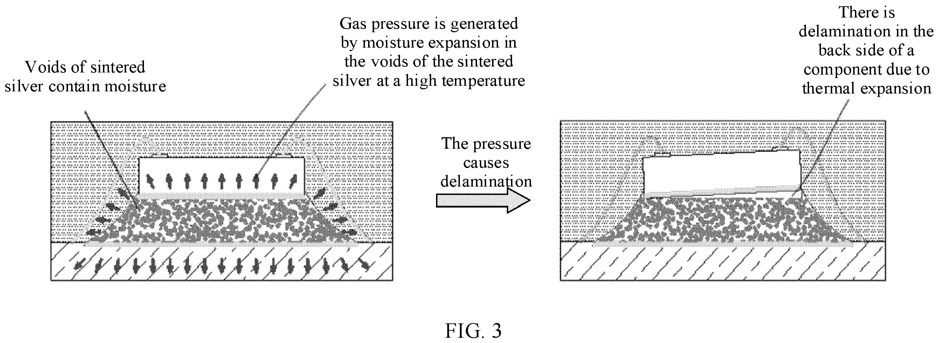

In a high-temperature sintering process, a large quantity of voids (void) are generated in the sintered metal. In other words, the sintered metal is full of a large quantity of voids. When the semiconductor chip and the substrate are bonded with the sintered metal, the voids exist in the semiconductor chip molding structure. In this case, when the semiconductor chip molding structure is exposed to humid air for a long time, the humid air gathers in the voids of the sintered metal, and consequently, a gas environment in the voids of the sintered metal is consistent with a gas environment outside the molding structure. Referring to FIG. 3, if a component baking and dehumidification step is skipped before the component of the molding structure is attached, when the component of the molding structure is surface-mounted onto a printed circuit board through reflow soldering, pressure caused by rapid heat expansion of moisture in the voids is easily generated inside the component of the molding structure. This causes delamination between the chip and the substrate, or even burst of the component of the molding structure.

Currently, a scanning acoustic tomography image is an effective means for verifying delamination in the semiconductor chip molding structure. It is difficult to distinguish between a scanning acoustic tomography image of the voids inside the sintered metal and a scanning acoustic tomography image of the delamination in the molding structure. Therefore, the voids inside the sintered metal interfere with detection of the delamination, and accuracy of detecting whether there is delamination in the semiconductor chip molding structure is relatively low.

It should be noted that, in the embodiments of this application, the delamination in the molding structure mainly refers to delamination between the semiconductor chip and a connection structure and delamination between the connection structure and the substrate.

To overcome the foregoing defects of the semiconductor chip molding structure, an embodiment of this application provides a semiconductor apparatus. For details, refer to the following embodiments.

It should be noted that, in an optional case, the semiconductor apparatus in this embodiment of this application may have a molding structure.

FIG. 4' is a perspective view of a semiconductor apparatus according to an embodiment of this application; and FIG. 4 is a schematic cross-sectional diagram of a semiconductor apparatus having a molding structure according to an embodiment of this application. As shown in FIG. 4' and FIG. 4, the semiconductor apparatus 400 includes:
a semiconductor chip 41, a substrate 42, and a bonding layer 43 located between the semiconductor chip 41 and the substrate 42, and the bonding layer 43 is used to bond the semiconductor chip 41 and the substrate 42.

The semiconductor apparatus 400 further includes a molding package 44 wrapping around the semiconductor chip 41 and the bonding layer 43.

The bonding layer 43 is made of sintered silver; there are a plurality of voids 431 inside the sintered silver, and at least some of the voids 431 are filled with a specific material 45; and the specific material has fluidity at a temperature higher than a preset temperature, and can be cured after being heated and melted.

It should be noted that, in this embodiment of this application, the curing means that after the specific material is heated and melted, a chemical crosslinking reaction occurs inside the material, and a chemical crosslinking bond is formed. After being heated again, the cured material does not melt and flow.

In this embodiment of this application, after the bonding layer 43 is formed through a sintering and curing process, the specific material 45 may be injected from the outside of the bonding layer 43 into the voids, to fill the voids.

Moreover, a quantity of the voids 431 inside the sintered silver is closely correlated with external moisture gathering inside the entire semiconductor apparatus. The fewer the voids, the less the external moisture gathers inside. The more the voids, the more the external moisture gathers inside. Therefore, to avoid delamination, of the chip and the substrate in the entire semiconductor apparatus, due to gathering of external moisture inside, in an optional embodiment of this application, the specific material may have relatively good fluidity at a temperature higher than the preset temperature. Then, the specific material can flow into and fill as many voids as possible, thereby reducing the voids in the entire semiconductor apparatus. Finally, little or even no moisture gathers in the semiconductor apparatus, thereby eliminating a risk of delamination between the chip and the substrate in the semiconductor apparatus. In this embodiment of this application, a proportion of filled voids may be controlled by controlling viscosity of the specific material. In an optional case, lower viscosity of the material indicates better fluidity of the material, a material with better fluidity can flow into more voids, and more voids are filled. For example, to fill as many voids as possible, a material with low viscosity may be selected as the specific material to fill the voids.

In another optional embodiment of this application, to simplify a packaging process and reduce packaging costs, the specific material in this embodiment of this application may be a molding material forming the molding package 44. Then, filling of the voids and forming of the molding package can be performed simultaneously, and the step of filling the voids does not need to be performed separately, simplifying the packaging process and reducing the packaging costs.

In addition, main ingredients of the molding material are resin, filler, and curing agent. In addition, other ingredients of the molding material may further include a catalyst, a mold release agent, and the like. Only when a processing temperature is higher than a melting temperature of the resin, the molding material can flow and deform. Therefore, in this embodiment, the preset temperature may be the melting temperature of the resin forming the molding material. In addition, to make the molding material have relatively good fluidity, the preset temperature may be a temperature higher than the melting temperature to some extent. This is not limited in this embodiment of this application.

In addition, after the molding material is heated and melted, a chemical reaction occurs between the resin inside and the curing agent, so that the molding material can be cured.

In another optional case, the specific material may alternatively be another material, for example, a silicone material.

In addition, in another optional embodiment of this application, to ensure that the semiconductor apparatus provided in this embodiment of this application can overcome the foregoing defects, the voids filled with the specific material account for at least 85% or even at least 90% of all the voids. In other words, at least 85% or even at least 90% of the voids are filled with the specific material. For example, a proportion of the voids filled with the specific material may be controlled by controlling viscosity of the molding material in the molding packaging process. For example, lower viscosity of the molding material indicates that more molding materials can flow into the voids, and the proportion of the voids filled with the specific material is higher.

In addition, in this embodiment of this application, in the semiconductor chip 41, optionally, the back side of the semiconductor chip 41 is bonded to the substrate 42. It should be noted that the back side of the semiconductor chip 41 is a surface opposite to a surface on which a chip active region (active region) is located. When a metal layer is disposed on the back side of the semiconductor chip 41, that is, a metal layer is disposed on a semiconductor chip surface that is bonded to the bonding layer 43, in a sintering process of a silver paste of sintered silver, silver particles in the silver paste form a metallic bond with the metal layer on the back side of the semiconductor chip 41, so that a metal alloy layer is formed. In an optional embodiment of this application, a first metal layer 411 is disposed on the semiconductor chip surface that is bonded to the bonding layer 43, and a first metal alloy layer 46 is formed between the first metal layer 411 and the bonding layer 43 due to a metallic bonding force.

In addition, usually, a metal layer is also disposed on a surface that is of the substrate 42 and that is bonded to the bonding layer 43. In the sintering process of the silver paste of sintered silver, silver in the silver paste forms a metallic bond with a surface that is of the metal layer and that is in contact with the silver. Therefore, a metal alloy layer is formed between the substrate 42 and the bonding layer 43. In an optional embodiment of this application, a second metal layer 421 is disposed on the substrate surface that is bonded to the bonding layer 43, and a second metal alloy layer 47 is formed between the second metal layer 421 and the bonding layer 43 due to a metallic bonding force.

In an optional case, in this embodiment of this application, a metallic material that forms the first metal layer 411 may be gold, because gold is not easy to oxidize and is not easy to react with another material at a normal temperature, and has relatively good bonding performance. Optionally, the first metal layer may also be another metal such as silver, tin, or copper. Optionally, a metallic material that forms the second metal layer 431 may be gold, silver, tin, or copper. In addition, the metallic material that forms the first metal layer 411 or the second metal layer 431 may be another metal that can be used to generate a metal alloy layer with the bonding layer. A metal type of the first metal layer and a metal type of the second metal layer are not limited in this application.

In addition, in another optional embodiment of this application, in addition to wrapping around the semiconductor chip 41 and the bonding layer 43, the molding package 44 may further wrap around the substrate 42, to protect the substrate 42 against damage from an external force.

The foregoing is a specific implementation of the semiconductor apparatus provided in this embodiment of this application. In this specific implementation, the sintered silver is used to form the bonding layer 43 that is used to connect the semiconductor chip 41 and the substrate 42. The sintered silver has good electrical and thermal conductivity, where the thermal conductivity reaches 100 w/m·k or higher. Therefore, heat generated when the semiconductor chip 41 works can be dissipated to the outside of the semiconductor apparatus through the bonding layer 43 and the substrate 42, thereby reducing overall thermal resistance from a PN junction on the front side to a chip housing of the semiconductor chip 41, and helping extending a lifespan of the semiconductor chip 41. In addition, this also helps increase input power of the semiconductor chip, increase power density of the semiconductor chip, and increase use power of the semiconductor chip.

In addition, in this embodiment of this application, at least some of the voids 431 in the sintered metal are filled with the specific material. After the voids 431 are filled with the specific material, less moisture is gathered inside the voids, and moisture in an external environment is prevented from gathering inside the semiconductor chip molding structure. Further, delamination between the chip and the substrate caused when external moisture gathers inside is avoided. Therefore, when the semiconductor molding structure is exposed to a humid environment, a probability that moisture in the external environment gathers inside the molding structure of the semiconductor apparatus is greatly reduced. Therefore, a possibility of delamination between the semiconductor chip 41 and the substrate 42 when the semiconductor apparatus is surface-mounted onto a printed circuit board through reflow soldering is reduced.

In addition, when a scanning acoustic tomography is used to detect whether there is delamination in the semiconductor chip molding structure, because a scanning acoustic tomography image of the filled voids is substantially different from a scanning acoustic tomography image of internal delamination of the semiconductor chip molding structure, based on this, the image of the filled voids can be easily excluded by using the scanning acoustic tomography image, thereby reducing interference to detection of delamination. Therefore, accuracy of detecting internal delamination of the semiconductor chip molding structure provided in this embodiment of this application is relatively high.

In addition, in this embodiment of this application, the back side of the semiconductor chip 41 is usually a surface of a metal layer and belongs to a metal system, and the bonding layer 43 is made of sintered silver and also belongs to a metal system. In a process of forming the bonding layer 43, the sintered silver forms a metallic bond with metal on a surface that is of the semiconductor chip 41 and that is in contact with the sintered silver. Therefore, a firm connection can be formed between the semiconductor chip 41 and the bonding layer 43. The firm connection can reduce a possibility of delamination between the semiconductor chip 41 and the bonding layer 43.

Based on the same principle, a firm connection is formed between the substrate 42 and the bonding layer 43. The firm connection can also reduce a possibility of delamination between the substrate 42 and the bonding layer 43.

It should be noted that in the foregoing embodiment, a specific structure of the bonding layer 43 is illustrated by using the sintered silver as an example. Actually, as an extension of this embodiment of this application, the bonding layer 43 is not limited to the sintered silver material, and can be made of any kind of sintered metal. Provided that the bonding layer 43 is made of sintered metal made through a metal powder sintering process, the semiconductor apparatus falls within the protection scope of this application. For example, when the bonding layer is made of sintered metal made through a metal powder sintering process, the metal powder may include at least one of nanometer and micrometer metal particles.

The foregoing is a specific implementation of the semiconductor apparatus provided in this embodiment of this application. Based on the specific implementation of the semiconductor apparatus, an embodiment of this application further provides a specific implementation of a semiconductor apparatus production method. For details, refer to the following embodiments.

It should be noted that, in this embodiment of this application, a specific implementation of the semiconductor apparatus production method provided in this embodiment of this application is described by using an example in which sintered silver is used as sintered metal. In addition, when another type of sintered metal other than the sintered silver is applied to this embodiment of this application, a specific implementation is the same as the specific implementation using the sintered silver, and a difference lies in a curing condition of the sintered metal. Therefore, a person skilled in the art can easily figure out an implementation using another type of sintered metal based on the specific implementation using the sintered silver, and a specific implementation of the another type of sintered metal is not described in detail herein.

Referring to FIG. 5 to FIG. 6C, a semiconductor apparatus production method provided in an embodiment of this application includes the following steps.

S501: Bond a semiconductor chip 41 onto a substrate 42 with a raw paste 61 of sintered silver.

An example is shown in FIG. 6A. A die bonder (die bonder) may be used to bond the semiconductor chip 41 onto the substrate 42 with the raw paste 61 of the sintered silver.

In a specific example of this application, S501 may be specifically: applying the raw paste of the sintered silver over the substrate 42, and placing the semiconductor chip 41 attached to the die bonder on the raw paste 61 of the sintered silver applied over the substrate 42. Then, the process of bonding the semiconductor chip 41 onto the substrate 42 is completed.

It should be noted that, in this embodiment of this application, the raw paste 61 of the sintered silver includes nanometer or micrometer silver powder particles 611 and an auxiliary solvent 612. As an example, the auxiliary solvent 612 may be one of butyl anhydride acetate ester, diethylene glycol butyl ether acetate ester, diethylene glycol ether acetate ester, or isophorone.

S502: Cure the raw paste 61 of the sintered silver, to form a bonding layer 43 that bonds the semiconductor chip 41 and the substrate 42, where the bonding layer 43 includes the cured sintered silver, and there are a plurality of voids 431 inside the sintered silver.

This step may be specifically: curing and sintering the raw paste 61 of the sintered silver (which may also be referred to as a sintered silver paste) in an oven or on a heating stage according to an oven temperature curve of the sintered silver and a corresponding baking gas. In the curing and sintering process, the auxiliary solvent 612 in the raw paste 61 of the sintered silver is volatilized, and the nanometer or micrometer silver powder particles 611 crystallize and gather into a sintered silver block, thereby forming the bonding layer 43 that connects the semiconductor chip 41 and the substrate 42. The bonding layer 43 is made of the cured sintered silver, and there are a plurality of voids 431 inside the sintered silver.

In an optional embodiment of this application, when a first metal layer 411 is disposed on a semiconductor chip surface that is bonded to the bonding layer 43, the semiconductor apparatus production method in this embodiment of this application may further include the following step:

When the raw paste 61 of the sintered silver is cured, a first metal alloy layer 46 is formed between the first metal layer 411 and the bonding layer 43 through sintering.

It should be noted that, when the raw paste 61 of the sintered silver is cured, under an effect of high-temperature sintering, metal atoms in the first metal layer 411 perform a bonding interaction with silver in the sintered silver to form a metallic bond. Then, the first metal alloy layer 46 is formed between the first metal layer 411 and the bonding layer 43 by sintering.

In another optional embodiment of this application, when a second metal layer 421 is disposed on a surface that is of the substrate 42 and that is in contact with the bonding layer 43, the semiconductor apparatus production method in this embodiment of this application may further include the following step:

When the raw paste 61 of the sintered silver is cured, a second metal alloy layer 47 is formed between the second metal layer 421 and the bonding layer 43 through sintering.

It should be noted that, when the raw paste 61 of the sintered silver is cured, under an effect of high-temperature sintering, metal atoms in the second metal layer 421 perform a bonding interaction with silver in the sintered silver to form a metallic bond. Then, the first metal alloy layer 47 is formed between the second metal layer 421 and the bonding layer 43 by sintering.

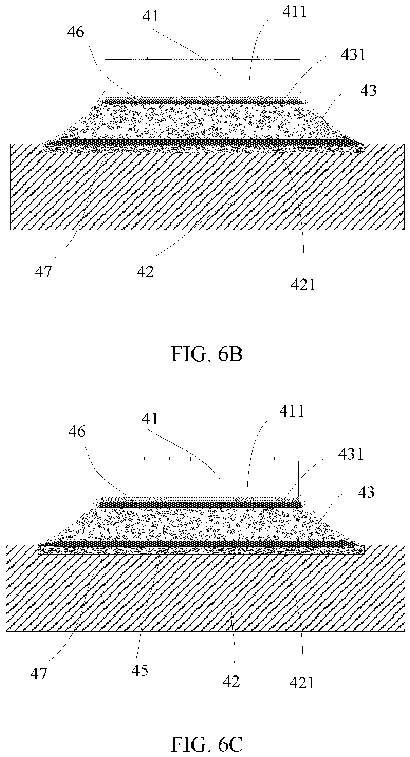

FIG. 6B is a schematic cross-sectional structural diagram after this step is performed.

S503: Fill at least some of the voids 431 with a specific material.

It should be noted that, in this embodiment of this application, the specific material has fluidity at a temperature higher than a preset temperature, and can be cured after being heated and melted.

To enable the specific material to fill as many voids as possible and achieve a relatively good filling effect, in this embodiment of this application, a material with relatively good fluidity is selected as the specific material to fill the voids. For example, the specific material may be a molding material with relatively good fluidity. In a specific embodiment, the selected specific material can fill at least some of the voids. In addition, to ensure that a final semiconductor molding structure can overcome defects of a semiconductor molding structure in the prior art, in an optional embodiment of this application, the selected specific material can fill at least 85% or even at least 90% of the voids.

As an example, step S503 may specifically include the following steps:

S5031: Heat the specific material to a temperature higher than the preset temperature, so that the specific material becomes a flowing fluid.

S5032: Inject the flowing fluid into the at least some of the voids in the bonding layer.

It should be understood that the flowing fluid is injected into the at least some of the voids in the bonding layer according to the principle of a capillary force. The capillary force refers to a phenomenon in which a wetting liquid rises in a thin tube and a phenomenon in which a non-wetting liquid falls in a thin tube. A vessel in a stem of a plant is an extremely thin capillary inside the plant, and can draw up water in the earth. Water absorption into a brick, sweat absorption into a towel, and ink being drawn into a fountain pen are all common capillary phenomena. In these objects, many small pores act as capillaries. Surface tension, cohesion, and adhesion of a liquid together can draw up water to a particular height in a capillary with a relatively small diameter. This is referred to as a capillary phenomenon.

The capillary force is a force that can draw up the fluid in the capillary without the assistance of external forces.

In this embodiment of this application, all the voids in the bonding layer are very small openings, and a structure of the void is similar to a capillary. Then, a structure of the bonding layer is placed inside the flowing fluid, and under the capillary force, the fluid can be injected into the at least some of the voids in the bonding layer.

S5033: Place the structure filled with the specific material in a specific temperature condition, and post-cure the fluid injected into the voids.

It should be noted that a temperature and a time of post-curing may be determined based on performance of the specific material. As an example, the temperature of post-curing may be related to a melting temperature of resin inside the specific material and a curing temperature of a curing agent.

FIG. 6C is a schematic cross-sectional structural diagram after this step is performed.

S504: Perform, by using a molding material, molding packaging on the semiconductor chip 41 and the substrate 42 that are connected together, to form a molding package 44 wrapping around the semiconductor chip 41 and the bonding layer 43.

This step may be specifically: depending on performance of the molding material, performing, at an appropriate molding temperature, molding packaging on the semiconductor chip 41 and the substrate 42 that are connected together, to form the molding package 44 wrapping around the semiconductor chip 41 and the bonding layer 43. A formed structure is shown in FIG. 4.

In addition, in another optional embodiment of this application, a molding package wrapping around the substrate 42 may be further formed around the substrate 42, to protect the substrate 42 against damage from an external force.

It should be noted that, in this embodiment of this application, before molding packaging is performed, another chip packaging step between die bonding and molding packaging may be further performed, for example, fabrication of a metallic bonding wire 48 that connects the front side of the semiconductor chip 41 and the substrate 42. It should be understood that the metallic bonding wire 48 is a metal leading wire, and is used to implement an electrical connection between a pad on the front side of the semiconductor chip 41 and a pad on the substrate 42.

S505: Cure the molding package 44.

According to a curing condition of the molding material, a molded semiconductor chip molding structure is placed under a corresponding temperature and atmosphere condition, and the molding package 44 is cured, to finally obtain a cured semiconductor chip molding structure.

The foregoing is a specific implementation of a semiconductor apparatus production method provided in this embodiment of this application.

In this specific implementation, the voids inside the sintered silver are filled through a dedicated filling process.

Because the specific material filled in the voids may be a molding material, to simplify a packaging process and reduce packaging costs, the process of filling the voids may be completed in the molding packaging process. For details, refer to the following embodiments.

Referring to FIG. 7, another semiconductor apparatus production method provided in an embodiment of this application includes the following steps.

S701 and S702 are the same as S501 to S502 in the foregoing embodiment. For brevity, details are not described herein again.

S703: Perform, by using a molding material, molding packaging on the semiconductor chip 41 and the substrate 42 that are bonded together, to form a molding package 44 wrapping around the semiconductor chip 41 and the bonding layer 43. During molding packaging, the molding material flows into at least some of the voids 431, so that the at least some of the voids 431 are filled with the molding material.

When the molding material is used to perform molding packaging on the semiconductor chip 41 and the substrate 42 that are connected together, under an action of molding pressure and a capillary force, the molding material in a melt state can flow into the at least some of the voids. Then, the at least some of the voids are filled with the molding material.

In this embodiment of this application, during molding packaging, the molding material in the melt state flows into the voids, to fill the voids. In the process of molding packaging, the molding material flows into the voids under the joint action of the molding pressure and the capillary force. Compared with the case of the capillary force only, a better filling effect can be achieved through the molding packaging process to fill the voids.

S704 is the same as S505. For brevity, details are not described herein again.

The foregoing is a specific implementation of another semiconductor apparatus production method provided in this embodiment of this application. In this specific implementation, voids are filled in the molding packaging process, so that the void filling process is omitted, a packaging process is simplified, and packaging costs are reduced.

The foregoing is specific implementations of the semiconductor apparatus and the semiconductor apparatus production method according to the embodiments of this application. It should be understood that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof. These modifications or replacements do not make the essence of the corresponding technical solutions fall outside the scope of the technical solutions of the embodiments of this application.

## Claims

1. A semiconductor apparatus, comprising:
a semiconductor chip, a substrate, and a bonding layer located between the semiconductor chip and the substrate, and the bonding layer is used to bond the semiconductor chip and the substrate, wherein
the bonding layer comprises sintered metal; a plurality of voids are inside the sintered metal, and at least some of the voids are filled with a specific material; and the specific material has fluidity at a temperature higher than a preset temperature, and can be cured after being heated and melted.

2. The semiconductor apparatus according to claim 1, wherein the semiconductor apparatus further comprises a molding package wrapping around the semiconductor chip and the bonding layer, and the specific material is the same as a molding material corresponding to the molding package.

3. The semiconductor apparatus according to claim 1 or 2, wherein at least 85% of the voids inside the sintered metal are filled with the specific material.

4. The semiconductor apparatus according to any one of claims 1 to 3, wherein a first metal layer is disposed on a semiconductor chip surface that is bonded to the bonding layer, and a first metal alloy layer is formed between the first metal layer and the bonding layer due to a metallic bonding force.

5. The semiconductor apparatus according to any one of claims 1 to 4, wherein a second metal layer is disposed on a substrate surface that is bonded to the bonding layer, and a second metal alloy layer is formed between the second metal layer and the bonding layer due to a metallic bonding force.

6. A semiconductor apparatus production method, wherein the production method comprises:
forming a bonding layer between a semiconductor chip and a substrate through a sintering and curing process, wherein the bonding layer is used to bond the semiconductor chip and the substrate, the bonding layer is made of sintered metal, and a plurality of voids are inside the sintered metal; and
filling at least some of the voids with a specific material, wherein the specific material has fluidity at a temperature higher than a preset temperature, and can be cured after being heated and melted.

7. The production method according to claim 6, wherein the production method further comprises:
forming a molding package wrapping the semiconductor chip and the bonding layer, wherein the specific material is the same as a molding material corresponding to the molding package.

8. The production method according to claim 6 or 7, wherein at least 85% of the voids inside the sintered metal are filled with the specific material.

9. The production method according to claim 7 or 8, wherein the filling at least some of the voids with a specific material specifically comprises:
flowing, by the flowing molding material, into the at least some of the voids when the molding package is formed, so that the at least some of the voids are filled with the molding material.

10. The production method according to any one of claims 6 to 9, wherein after the forming a molding package wrapping the semiconductor chip and the bonding layer, the production method further comprises: curing the molding package.

11. The production method according to any one of claims 6 to 10, wherein the filling at least some of the voids with a specific material specifically comprises:
heating the specific material to a temperature higher than the preset temperature, so that the specific material can flow; and
injecting the flowing specific material into the at least some of the voids in the bonding layer.

12. The production method according to any one of claims 6 to 11, wherein a first metal layer is disposed on a semiconductor chip surface that is bonded to the bonding layer, and a first metal alloy layer is formed between the first metal layer and the bonding layer due to a metallic bonding force.

13. The production method according to any one of claims 6 to 12, wherein a second metal layer is disposed on a substrate surface that is bonded to the bonding layer, and a second metal alloy layer is formed between the second metal layer and the bonding layer due to a metallic bonding force.
